# EUROPÄISCHE PATENTANMELDUNG

(11) **EP 4 187 200 A1**
(43) Veröffentlichungstag der Anmeldung: **31.05.2023**
(21) Anmeldenummer: 22205111.2
(22) Anmeldetag: 02.11.2022
(51) Int. Cl.: G01C 15/00

(54) **VERFAHREN ZU EINEM BETRIEB EINER REGELUNGS- UND ÜBERWACHUNGSVORRICHTUNG FÜR EINEN ROTATIONSLASER, DIE REGELUNGS- UND ÜBERWACHUNGSVORRICHTUNG UND DER ROTATIONSLASER**

(30) Priorität: 30.11.2021 DE 102021213460
(71) Anmelder: Robert Bosch GmbH, 70442 Stuttgart (DE)
(72) Erfinder: Zibold, Tobias, 70567 Stuttgart (DE); Albrecht, Andrej, 70771 Leinfelden-Echterdingen (DE); Hahl, Markus, 70825 Korntal-Muenchingen (DE)

(57) **Zusammenfassung**

Die Erfindung geht aus von einem Verfahren zu einem Betrieb einer Regelungsund Überwachungsvorrichtung (10) für einen Rotationslaser (12), wobei in einem Verfahrensschritt (22) mittels einer Steuer- oder Regeleinheit (14) der Regelungs- und Überwachungsvorrichtung (10) eine Laserleistung einer Lasereinheit (16) des Rotationslasers (12) in Abhängigkeit von einer Rotationsgeschwindigkeit eines Rotationskopfs (18) des Rotationslasers (12) geregelt wird.

Es wird vorgeschlagen, dass mittels einer weiteren Steuer- oder Regeleinheit (20) der Regelungs- und Überwachungsvorrichtung (10) die Rotationsgeschwindigkeit des Rotationskopfs (18) und zumindest ein Betriebsparameter der Lasereinheit (16) abgefragt und abgeglichen wird, um ein Signal zu einer Beeinflussung eines mittels der Lasereinheit (16) ausgebbaren Laserstrahls auszugeben.

## Beschreibung

### Stand der Technik

Es ist bereits ein Verfahren zu einem Betrieb einer Regelungs- und Überwachungsvorrichtung für einen Rotationslaser, wobei in einem Verfahrensschritt mittels einer Steuer- oder Regeleinheit der Regelungs- und Überwachungsvorrichtung eine Laserleistung einer Lasereinheit des Rotationslasers in Abhängigkeit von einer Rotationsgeschwindigkeit eines Rotationskopfs des Rotationslasers geregelt wird, vorgeschlagen worden.

### Offenbarung der Erfindung

Die Erfindung geht aus von einem Verfahren zu einem Betrieb einer Regelungs- und Überwachungsvorrichtung für einen Rotationslaser, wobei in einem Verfahrensschritt mittels einer Steuer- oder Regeleinheit der Regelungs- und Überwachungsvorrichtung eine Laserleistung einer Lasereinheit des Rotationslasers in Abhängigkeit von einer Rotationsgeschwindigkeit eines Rotationskopfs des Rotationslasers geregelt wird.

Es wird vorgeschlagen, dass mittels einer weiteren Steuer- oder Regeleinheit der Regelungs- und Überwachungsvorrichtung die Rotationsgeschwindigkeit des Rotationskopfs und zumindest ein Betriebsparameter der Lasereinheit abgefragt und abgeglichen wird, um ein Signal zu einer Beeinflussung eines mittels der Lasereinheit ausgebbaren Laserstrahls auszugeben.

Die Steuer- oder Regeleinheit umfasst insbesondere zumindest einen Prozessor und ein Speicherelement sowie ein auf dem Speicherelement gespeichertes Betriebsprogramm. Das Speicherelement ist vorzugsweise als digitales Speichermedium, beispielsweise als eine Festplatte oder dergleichen ausgebildet. Die Steuer- oder Regeleinheit ist vorzugsweise als Mikrocontroller oder als eine andere, einem Fachmann als sinnvoll erscheinende Steuer- oder Regeleinheit ausgebildet. Der Rotationslaser umfasst vorzugsweise zumindest eine Antriebseinheit zu einem Antrieb des Rotationskopfs. Die Antriebseinheit ist vorzugsweise als Elektromotor oder dergleichen ausgebildet. Die Lasereinheit ist vorzugsweise, insbesondere zumindest teilweise, an dem Rotationskopf angeordnet. Bevorzugt weist der Rotationskopf zumindest ein Umlenkelement, beispielsweise einen Spiegel, ein Prisma oder dergleichen, auf, welches dazu vorgesehen ist, den mittels der Lasereinheit ausgebbaren Laserstrahl derart umzulenken, insbesondere um 90 °, dass durch eine Rotation des Rotationskopfs der Laserstrahl in einem Winkelbereich, insbesondere von mehr als 15°, bevorzugt von mehr als 75°, besonders bevorzugt von mehr als 180° und ganz besonders bevorzugt von 360 ° um eine Rotationsachse des Rotationskopfs ausgegeben wird. Vorzugsweise wird mittels der Steuer- oder Regeleinheit die Rotationsgeschwindigkeit des Rotationskopfs gesteuert oder geregelt, bevorzugt über eine Steuerung oder Regelung der Antriebseinheit durch die Steuer- oder Regeleinheit. Vorzugsweise wird eine Rotationsgeschwindigkeit, insbesondere eine Soll-Rotationsgeschwindigkeit, des Rotationskopfs über eine Eingabeeinheit, die insbesondere steuer- oder regeltechnisch, bevorzugt datentechnisch, beispielsweise kabelgebunden oder kabellos, mit der Steuer- oder Regeleinheit verbunden ist, eingestellt. Es ist denkbar, dass die Eingabeeinheit ein Tastenfeld, einen Drehregler, ein Touchscreen, einen Schieberegler, eine Fernbedienung oder dergleichen umfasst. Es ist denkbar, dass die Regelungs- und Überwachungsvorrichtung oder der Rotationslaser die Eingabeeinheit umfasst. Beispielsweise wird eine Rotationsgeschwindigkeit, insbesondere eine Soll-Rotationsgeschwindigkeit, des Rotationskopfs durch eine Eingabe eines Nutzers über die Eingabeeinheit eingestellt. Es ist auch denkbar, dass die Rotationsgeschwindigkeit, insbesondere eine Soll-Rotationsgeschwindigkeit, des Rotationskopfs automatisch mittels der Steuer- oder Regeleinheit eingestellt wird.

Mittels der Steuer- oder Regeleinheit wird insbesondere die tatsächliche Rotationsgeschwindigkeit, insbesondere eine Ist-Rotationsgeschwindigkeit, des Rotationskopfs abgefragt und/oder ermittelt. Beispielsweise wird die Rotationsgeschwindigkeit, insbesondere die Ist-Rotationsgeschwindigkeit, des Rotationskopfs direkt an dem Rotationskopf abgefragt und/oder ermittelt oder in Abhängigkeit von einer mittels der Steuer- oder Regeleinheit abgefragten Rotationsgeschwindigkeit, insbesondere einer Ist-Rotationsgeschwindigkeit, der Antriebseinheit ermittelt. Insbesondere ist in Abhängigkeit von einer Rotationsgeschwindigkeit des Rotationskopfs, vorzugsweise der Antriebeinheit, eine Betriebsart des Rotationskopfs bestimmbar. Bevorzugt kann die Betriebsart des Rotationskopfs ein Stillstand des Rotationskopfs sein, eine Rotation des Rotationskopfs mit unterschiedlichen Rotationsgeschwindigkeiten, beispielsweise 150 U/min, 300 U/min, 600 U/min, 1200 U/min oder andere, einem Fachmann also sinnvoll erscheinende Rotationsgeschwindigkeiten, eine Rotationsrichtung einer Rotation des Rotationskopfs oder dergleichen sein. Bevorzugt wird in Abhängigkeit von der ermittelten Rotationsgeschwindigkeit, insbesondere der Ist-Rotationsgeschwindigkeit, vorzugsweise der ermittelten Betriebsart, des Rotationskopfs mittels der Steuer- oder Regeleinheit eine Laserleistung, insbesondere eine Soll-Laserleistung, der Lasereinheit eingestellt. Alternativ ist auch denkbar, dass die Laserleistung, insbesondere die Soll-Laserleistung, mittels der Steuer- oder Regeleinheit direkt in Abhängigkeit von einer vorgenommenen Einstellung für die Rotationsgeschwindigkeit, insbesondere der Soll-Rotationsgeschwindigkeit, des Rotationskopfs eingestellt wird.

Die Lasereinheit umfasst vorzugsweise eine Laserdiode. Die Lasereinheit umfasst vorzugsweise zumindest eine Treiberschaltung, um die Laserdiode anzuregen. Bevorzugt ist die Treiberschaltung zu einer elektrischen Anregung der Laserdiode eingerichtet. Alternativ ist auch denkbar, dass die Treiberschaltung zu einem optischen Pumpen des Lasers eingerichtet ist. Alternativ ist auch denkbar, dass die Lasereinheit einen Gaslaser, einen Farbstofflaser, oder einen von der Laserdiode verschiedenen Festkörperlaser umfasst. Vorzugsweise wird die Laserleistung, insbesondere die Soll-Laserleistung, der Lasereinheit mittels der Steuer- oder Regeleinheit in Abhängigkeit von der ermittelten Rotationsgeschwindigkeit, insbesondere der Ist-Rotationsgeschwindigkeit, des Rotationskopfs derart eingestellt, dass ein maximaler Wert der Laserleistung innerhalb eines Soll-Grenzwertbereichs, der vorzugsweise auf dem Speicherelement der Steuer- oder Regeleinheit hinterlegt ist, für die Laserleistung bei der entsprechenden Rotationsgeschwindigkeit, insbesondere der Ist-Rotationsgeschwindigkeit, des Rotationskopfs liegt. Der Soll-Grenzwertbereich für die Laserleistung ist vorzugsweise abhängig von einer Rotationsgeschwindigkeit, insbesondere einer Ist-Rotationsgeschwindigkeit, des Rotationskopfs, insbesondere von der Betriebsart des Rotationskopfs. Der Soll-Grenzwertbereich ist beispielsweise durch Sicherheitsbestimmungen zu einem Betrieb eines Lasers vorgegeben. Es ist denkbar, dass die Treiberschaltung verschieden von der Steuer- oder Regeleinheit ausgebildet ist. Es ist alternativ auch denkbar, dass die Treiberschaltung in die Steuer- oder Regeleinheit integriert ist, insbesondere die Treiberschaltung und die Steuer- oder Regeleinheit auf einer gemeinsamen Platine angeordnet sind. Ferner ist auch denkbar, dass die Lasereinheit zumindest ein Laserleistungsmesselement zu einer Erfassung einer Laserleistung, insbesondere einer Ist-Laserleistung, eines mittels der Lasereinheit ausgebbaren Laserstrahls umfasst. Das Laserleistungsmesselement ist vorzugsweise als Diode oder als ein anderes, einem Fachmann als sinnvoll erscheinendes Element zur Ermittlung einer Laserleistung, insbesondere einer Ist-Laserleistung, eines Laserstrahls ausgebildet. Beispielsweise wird mittels des als Diode ausgebildeten Laserleistungselements eine Laserleistung, insbesondere einer Ist-Laserleistung, des mittels der Lasereinheit erzeugbaren Laserstrahls über einen damit in der Diode erzeugten Photostrom ermittelt. Es ist zusätzlich oder alternativ denkbar, dass die Steuer- oder Regeleinheit die Laserleistung, insbesondere die Soll-Laserleistung, in Abhängigkeit von der mittels des Laserleistungsmesselements erfassten Laserleistung, insbesondere der Ist-Laserleistung, der Lasereinheit regelt.

Die weitere Steuer- oder Regeleinheit ist vorzugsweise als Mikrocontroller oder als eine andere, einem Fachmann als sinnvoll erscheinende Steuer- oder Regeleinheit ausgebildet. Die weitere Steuer- oder Regeleinheit ist bevorzugt verschieden von der Steuer- oder Regeleinheit ausgebildet. Alternativ ist auch denkbar, dass die Steuer- oder Regeleinheit und die weitere Steuer- oder Regeleinheit auf einer gemeinsamen Platine angeordnet sind. Vorzugsweise weisen die Steuer- oder Regeleinheit und die weitere Steuer- oder Regeleinheit voneinander verschiedene Betriebsprogramme auf. Mittels der weiteren Steuer- oder Regeleinheit wird insbesondere die Rotationsgeschwindigkeit, insbesondere die Ist-Rotationsgeschwindigkeit, des Rotationskopfs abgefragt und/oder ermittelt. Es ist denkbar, dass die Rotationsgeschwindigkeit, insbesondere die Ist-Rotationsgeschwindigkeit, des Rotationskopfs direkt an dem Rotationskopf mittels der weiteren Steuer- oder Regeleinheit abgefragt und/oder ermittelt wird oder in Abhängigkeit von einer Abfrage der Rotationsgeschwindigkeit, insbesondere der Ist-Rotationsgeschwindigkeit, der Antriebseinheit mittels der weiteren Steuer- oder Regeleinheit ermittelt wird. Vorzugsweise wird mittels der weiteren Steuer- oder Regeleinheit die Rotationsgeschwindigkeit, insbesondere die Ist-Rotationsgeschwindigkeit, des Rotationskopfs unabhängig von der Steuer- oder Regeleinheit ermittelt. Insbesondere wird die Rotationsgeschwindigkeit, insbesondere die Ist-Rotationsgeschwindigkeit, des Rotationskopfs mittels der Steuer- oder Regeleinheit und der weiteren Steuer- oder Regeleinheit, bevorzugt unabhängig voneinander und/oder auf zwei voneinander verschiedene Weisen, beispielsweise mittels unterschiedlicher Sensoren, ermittelt.

Vorzugsweise ist die weitere Steuer- oder Regeleinheit steuer- oder regeltechnisch, bevorzugt datentechnisch, insbesondere kabelgebunden oder kabellos, mit der Lasereinheit verbunden. Vorzugsweise wird mittels der weiteren Steuer- oder Regeleinheit in Abhängigkeit von dem zumindest einen Betriebsparameter der Lasereinheit eine Laserleistung, insbesondere eine Soll- und/oder eine Ist-Laserleistung, der Lasereinheit ermittelt. Die weitere Steuer- oder Regeleinheit gleicht vorzugsweise die mittels der weiteren Steuer- oder Regeleinheit abgefragte und/oder ermittelte Laserleistung, insbesondere die Soll- und/oder die Ist-Laserleistung, der Lasereinheit mit der mittels der weiteren Steuer- oder Regeleinheit abgefragten und/oder ermittelten Rotationsgeschwindigkeit, insbesondere der Ist-Rotationsgeschwindigkeit, des Rotationskopfs ab. Bevorzugt wird mittels der weiteren Steuer- oder Regeleinheit geprüft, ob ein maximaler Wert der mittels der weiteren Steuer- oder Regeleinheit abgefragten und/oder ermittelten Laserleistung, insbesondere der Soll- und/oder Ist-Laserleistung, der Lasereinheit innerhalb des Soll-Grenzwertbereichs, der vorzugsweise auf einem Speicherelement der weiteren Steuer- oder Regeleinheit hinterlegt ist, für die Laserleistung, insbesondere die Ist-Laserleistung, bei der entsprechenden Rotationsgeschwindigkeit, insbesondere der Ist-Rotationsgeschwindigkeit, des Rotationskopfs liegt. Insbesondere wird das Signal zu einer Beeinflussung eines mittels der Lasereinheit ausgebbaren Laserstrahls mittels der weiteren Steuer- oder Regeleinheit ausgegeben, wenn ein mittels der weiteren Steuer- oder Regeleinheit ermittelter maximaler Wert der Laserleistung, insbesondere der Soll- und/oder Ist-Laserleistung, des mittels der Lasereinheit ausgebbaren Laserstrahls außerhalb des Soll-Grenzwertbereichs für die Laserleistung bei der entsprechenden Rotationsgeschwindigkeit, insbesondere der Ist-Rotationsgeschwindigkeit, des Rotationskopfs liegt.

Das Signal zu einer Beeinflussung eines mittels der Lasereinheit ausgebbaren Laserstrahls ist insbesondere ein Signal zu einer Steuerung oder Regelung der Lasereinheit, insbesondere der Treiberschaltung der Lasereinheit, einer Stromversorgung der Lasereinheit und/oder der Laserdiode der Lasereinheit, oder ein Signal zu einer direkten Einflussnahme auf den mittels der Lasereinheit ausgebbaren Laserstrahl, beispielsweise zu einer Aktivierung einer Blockier- oder Umlenkeinheit der Regelungs- und Überwachungsvorrichtung zu einem Blockieren und/oder Umlenken des Laserstrahls oder dergleichen. Vorzugsweise wird mittels des Signals zu einer Beeinflussung eines mittels der Lasereinheit ausgebbaren Laserstrahls eine Laserleistung, insbesondere eine Soll-Laserleistung und/oder eine Ist-Laserleistung, der Lasereinheit geändert, vorzugsweise verringert, die Lasereinheit deaktiviert und/oder einer Ausbreitung des mittels der Lasereinheit ausgebbaren Laserstrahls entgegengewirkt. Bevorzugt wird mittels des Signals zu einer Beeinflussung des mittels der Lasereinheit ausgebbaren Laserstrahls die Laserleistung, insbesondere die Soll-Laserleistung und/oder die Ist-Laserleistung, derart geändert, beispielsweise verringert oder erhöht, dass ein maximaler Wert der Laserleistung, insbesondere der Ist-Laserleistung, innerhalb des Soll-Grenzwertbereichs für die Laserleistung bei der entsprechenden Rotationsgeschwindigkeit, insbesondere der Ist-Rotationsgeschwindigkeit, des Rotationskopfs liegt. Es ist denkbar, dass das Signal zu einer Beeinflussung eines mittels der Lasereinheit ausgebbaren Laserstrahls in Abhängigkeit von lediglich einem Betriebsparameter der Lasereinheit oder von mehreren Betriebsparametern der Lasereinheit ausgegeben wird.

Durch die erfindungsgemäße Ausgestaltung der Regelungs- und Überwachungsvorrichtung kann vorteilhaft ein besonders hoher Personenschutz im Betrieb eines Rotationslasers realisiert werden. Vorteilhaft kann eine redundante Steuerung einer Lasereinheit in Abhängigkeit von einer Rotationsgeschwindigkeit, insbesondere einer Ist-Rotationsgeschwindigkeit, eines Rotationskopfs bereitgestellt werden. Vorteilhaft kann ein fehlersicherer Betrieb der Regelungs- und Überwachungsvorrichtung für einen Rotationslaser realisiert werden. Es kann vorteilhaft zuverlässig und konstruktiv einfach eine Einfehlersicherheit der Regelungs- und Überwachungsvorrichtung ermöglicht werden.

Des Weiteren wird vorgeschlagen, dass mittels der weiteren Steuer- oder Regeleinheit ein als eine von der Steuer- oder Regeleinheit vorgenommene Laserleistungseinstellung, insbesondere eine Soll-Laserleistung, oder ein als eine von der Lasereinheit ausgebbare Laserleistung, insbesondere eine Ist-Laserleistung, ausgebildeter Betriebsparameter der Lasereinheit abgefragt wird. Alternativ ist auch denkbar, dass der Betriebsparameter ein Ist-Betriebsparameter der Lasereinheit oder dergleichen ist. Es ist denkbar, dass die mittels der Lasereinheit ausgebbare Laserleistung, insbesondere die Ist-Laserleistung, über das Laserleistungsmesselement der Lasereinheit erfasst wird und von der weiteren Steuer- oder Regeleinheit abgefragt wird. Alternativ oder zusätzlich ist auch denkbar, dass die weitere Steuer- oder Regeleinheit und/oder die Lasereinheit ein weiteres Laserleistungsmesselement, beispielsweise eine weitere Diode oder dergleichen, zu einer Erfassung einer Laserleistung, insbesondere einer Ist-Laserleistung, eines mittels der Lasereinheit ausgebbaren Laserstrahls umfasst. Die von der Steuer- oder Regeleinheit vorgenommene Laserleistungseinstellung ist beispielsweise als eine Steuer- oder Regelspannung, als eine digitale Steuerungs- oder Regelinformation oder dergleichen ausgebildet. Vorteilhaft kann eine besonders zuverlässige Überwachung und Regelung eines mittels einer Lasereinheit ausgebbaren Laserstrahls realisiert werden. Vorteilhaft kann einem Betrieb einer Lasereinheit außerhalb eines vorgesehenen Leistungsbereichs besonders sicher und effizient entgegengewirkt werden. Vorteilhaft kann eine besonders hohe Arbeitssicherheit für Personen in einem Wirkungsbereich eines Rotationslasers realisiert werden.

Weiterhin wird vorgeschlagen, dass eine, insbesondere die zuvor bereits genannte, Blockier- und/oder Umlenkeinheit der Regelungs- und Überwachungsvorrichtung zu einem Blockieren bzw. Umlenken des mittels der Lasereinheit ausgebbaren Laserstrahls in Abhängigkeit von dem mittels der weiteren Steuer- oder Regeleinheit ausgebbaren Signal aktiviert wird. Vorzugsweise ist die weitere Steuer- oder Regeleinheit steuer- oder regeltechnisch, insbesondere datentechnisch, vorzugsweise kabellos oder kabelgebunden, mit der Blockier- und/oder Umlenkeinheit verbunden, bevorzugt um das Signal zu einer Beeinflussung des mittels der Lasereinheit ausgebbaren Laserstrahls zu einer Ansteuerung oder Regelung der Blockier- und/oder Umlenkeinheit an die Blockier- und/oder Umlenkeinheit zu übertragen. Die Blockier- und/oder Umlenkeinheit umfasst insbesondere zumindest ein Blockierelement und/oder zumindest ein Umlenkelement. Das Blockierelement ist insbesondere als eine Klappe, als eine Blende oder als ein anderes, einem Fachmann als sinnvoll erscheinendes Element zu einem Blockieren eines Laserstrahls ausgebildet. Beispielsweise wird in Abhängigkeit von dem mittels der weiteren Steuer- oder Regeleinheit ausgebbaren Signal zu einer Beeinflussung des mittels der Lasereinheit ausgebbaren Laserstrahls das zumindest eine Blockierelement in einen Strahlengang des mittels der Lasereinheit ausgebbaren Laserstrahls gebracht, um den Laserstrahl zu blockieren. Das Umlenkelement ist beispielsweise als ein Spiegel, als ein Prisma oder als eine anderes, einem Fachmann als sinnvoll erscheinendes Element zu einem Umlenken eines Laserstrahls ausgebildet. Beispielsweise wird in Abhängigkeit von dem mittels der weiteren Steuer- oder Regeleinheit ausgebbaren Signal zu einer Beeinflussung des mittels der Lasereinheit ausgebbaren Laserstrahls das zumindest eine Umlenkelement in den Strahlengang des mittels der Lasereinheit ausgebbaren Laserstrahls gebracht, um den Laserstrahl umzulenken. Vorzugsweise wird der mittels der Lasereinheit ausgebbare Laserstrahl mittels der Blockier- und/oder Umlenkeinheit, insbesondere mittels des zumindest einen Umlenkelements und/oder des zumindest einen Blockierelements, in einem aktivierten Zustand der Blockier- und/oder Umlenkeinheit derart blockiert und/oder umgelenkt, dass der Laserstrahl von einer Ausstrahlung an eine Umgebung des Rotationslasers gehindert wird. Die Blockier- und/oder Umlenkeinheit, insbesondere das zumindest eine Blockierelement und/oder das zumindest eine Umlenkelement, sind bevorzugt an der Lasereinheit, vorzugsweise an der Laserdiode der Lasereinheit, angeordnet. Vorteilhaft kann ein besonders einfacher und sicherer Eingriff in eine Lasereinheit, insbesondere einen Strahlengang des Laserstrahls, zu einer Unterbindung eines nicht ordnungsgemäß mittels der Lasereinheit ausgegebenen Laserstrahls realisiert werden. Vorteilhaft kann eine Schutzfunktion besonders einfach überprüft werden.

Außerdem wird vorgeschlagen, dass mittels der weiteren Steuer- oder Regeleinheit zumindest ein Betriebsparameter, insbesondere ein Ist-Betriebsparameter, der Steuer- oder Regeleinheit abgefragt wird, um zumindest in Abhängigkeit von dem zumindest einen Betriebsparameter, insbesondere dem Ist-Betriebsparameter, der Steuer- oder Regeleinheit das Signal zu einer Beeinflussung des mittels der Lasereinheit ausgebbaren Laserstrahls mittels der weiteren Steuer- oder Regeleinheit auszugeben. Es ist denkbar, dass das Signal zu einer Beeinflussung eines mittels der Lasereinheit ausgebbaren Laserstrahls von dem zumindest einen Betriebsparameter der Lasereinheit zusätzlich oder alternativ von dem zumindest einen Betriebsparameter, insbesondere dem Ist-Betriebsparameter, der Steuer- oder Regeleinheit abhängt. Insbesondere ist der zumindest eine Betriebsparameter, insbesondere der Ist-Betriebsparameter, der Steuer- oder Regeleinheit ein die Laserleistung, insbesondere die Ist-Laserleistung, beeinflussender Betriebsparameter der Steuer- oder Regeleinheit. Ferner ist auch denkbar, dass das Signal zu einer Beeinflussung eines mittels der Lasereinheit ausgebbaren Laserstrahls alternativ oder zusätzlich von zumindest einem weiteren Betriebsparameter, insbesondere einem Ist-Betriebsparameter, eines weiteren Bauteils der Regelungs- und Überwachungsvorrichtung und/oder eines weiteren Bauteils des Rotationslasers, wobei der weitere Betriebsparameter, insbesondere der Ist-Betriebsparameter, vorzugsweise Einfluss auf eine mittels der Lasereinheit ausgebbare Laserleistung, vorzugsweise eine Ist-Laserleistung, hat, abhängt. Vorteilhaft kann eine mittels der Lasereinheit ausgebbare Laserleistung besonders flexibel und sicher überprüft werden. Vorteilhaft kann einem Betrieb der Lasereinheit mit einer Laserleistung, insbesondere einer Ist-Laserleistung, außerhalb eines Soll-Grenzwertbereichs für die Laserleistung besonders effizient und frühzeitig entgegengewirkt werden. Vorteilhaft kann ein besonders einfehlersicherer Betrieb des Rotationslasers realisiert werden.

Ferner wird vorgeschlagen, dass mittels der Steuer- oder Regeleinheit ein Sensorsignal eines Bewegungssensors einer Sensoreinheit des Rotationslasers und mittels der weiteren Steuer- oder Regeleinheit ein Sensorsignal eines weiteren Bewegungssensors der Sensoreinheit abgefragt wird, wobei eine, insbesondere die zuvor bereits genannte, Betriebsart, insbesondere eine durch eine Rotationsgeschwindigkeit, vorzugsweise eine Ist-Rotationsgeschwindigkeit, und/oder durch eine Rotationsrichtung definierte Betriebsart, des Rotationskopfs in Abhängigkeit von einer Auswertung einer zeitlichen Änderung der durch die Steuer- oder Regeleinheit und die weitere Steuer- oder Regeleinheit abgefragten Sensorsignale ermittelt wird. Vorzugsweise ist der Bewegungssensor verschieden von dem weiteren Bewegungssensor ausgebildet. Bevorzugt basieren der Bewegungssensor und der weitere Bewegungssensor auf voneinander verschiedenen Messmethoden zu einer Erfassung einer Rotationsgeschwindigkeit, insbesondere einer Ist-Rotationsgeschwindigkeit. Es ist auch denkbar, dass der Bewegungssensor und der weitere Bewegungssensor identisch ausgebildet sind, insbesondere auf identischen Messmethoden zu einer Erfassung einer Rotationsgeschwindigkeit basieren. Der Bewegungssensor und/oder der weitere Bewegungssensor sind/ist beispielsweise als optischer Encoder, als Magnetfeldsensor/en oder dergleichen ausgebildet. Alternativ ist auch denkbar, dass der Bewegungssensor und/oder der weitere Bewegungssensor als Akustiksensor/en oder als andere/r, einem Fachmann als sinnvoll erscheinende/r Sensor/en zur Erfassung einer Rotationsgeschwindigkeit, insbesondere einer Ist-Rotationsgeschwindigkeit, ausgebildet sind/ist. Die Sensoreinheit, insbesondere der Bewegungssensor und/oder der weitere Bewegungssensor, ist/sind an der Antriebseinheit und/oder an dem Rotationskopf angeordnet. Vorzugsweise wird die Betriebsart, insbesondere die Rotationsgeschwindigkeit, vorzugsweise die Ist-Rotationsgeschwindigkeit, des Rotationskopfs in Abhängigkeit von einer Auswertung einer zeitlichen Änderung des durch die Steuer- oder Regeleinheit abgefragten Sensorsignals des Bewegungssensors unabhängig von einer Ermittlung der Betriebsart, insbesondere der Rotationsgeschwindigkeit, vorzugsweise der Ist-Rotationsgeschwindigkeit, des Rotationskopfs in Abhängigkeit von einer Auswertung einer zeitlichen Änderung des durch die weitere Steuer- oder Regeleinheit abgefragten Sensorsignals des weiteren Bewegungssensors ermittelt. Vorteilhaft kann eine Rotationsgeschwindigkeit, insbesondere die Ist-Rotationsgeschwindigkeit, des Rotationskopfs besonders zuverlässig bestimmt werden. Vorteilhaft kann ein erfasster Wert für eine Rotationsgeschwindigkeit, insbesondere eine Ist-Rotationsgeschwindigkeit, besonders einfach und effizient gegengeprüft werden. Vorteilhaft kann einer unerwünschten Einstellung einer Laserleistung besonders effizient und präzise entgegengewirkt werden. Vorteilhaft kann ein besonders sicherer Betrieb eines Rotationslasers gewährleistet werden.

Des Weiteren wird vorgeschlagen, dass mittels der weiteren Steuer- oder Regeleinheit zumindest ein Betriebsparameter, vorzugsweise ein Ist-Betriebsparameter, insbesondere eine Spannungskenngröße, eines Verstärkers, insbesondere eines Operationsverstärkers, der Lasereinheit abgefragt wird, um zumindest in Abhängigkeit von dem zumindest einen Betriebsparameter des Verstärkers das Signal zu einer Beeinflussung des mittels der Lasereinheit ausgebbaren Laserstrahls mittels der weiteren Steuer- oder Regeleinheit auszugeben. Es ist denkbar, dass das Signal zu einer Beeinflussung eines mittels der Lasereinheit ausgebbaren Laserstrahls von dem als eine von der Steuer- oder Regeleinheit vorgenommene Laserleistungseinstellung, insbesondere der Soll-Laserleistung, oder als eine von der Lasereinheit ausgebbare Laserleistung, insbesondere der Ist-Laserleistung, ausgebildeter Betriebsparameter der Lasereinheit zusätzlich oder alternativ von dem zumindest einen Betriebsparameter des Verstärkers und/oder von dem zumindest einen Betriebsparameter der Steuer- oder Regeleinheit abhängt. Die Spannungskenngröße ist vorzugsweise ein Spannungspegel oder dergleichen. Vorzugsweise wird die Spannungskenngröße an einem Ausgang des Verstärkers gemessen. Es ist denkbar, dass der Verstärker als integrierte Schaltung implementiert ist. Insbesondere ist eine Laserleistung, insbesondere die Ist-Laserleistung, eines mittels der Lasereinheit ausgebbaren Laserstrahls von der Spannungskenngröße, insbesondere dem Spannungspegel, vorzugsweise an dem Ausgang, des Verstärkers abhängig. Es ist auch denkbar, dass das Signal zu einer Beeinflussung des mittels der Lasereinheit ausgebbaren Signals lediglich in Abhängigkeit von dem als eine von der Steuer- oder Regeleinheit vorgenommene Laserleistungseinstellung ausgebildeten Betriebsparameter, insbesondere einer Soll-Laserleistung, der Lasereinheit, von dem als eine von der Lasereinheit ausgebbare Laserleistung ausgebildeten Betriebsparameter, insbesondere der Ist-Laserleistung, der Lasereinheit, von dem zumindest einen Betriebsparameter der Steuer- oder Regeleinheit oder lediglich von dem zumindest einen Betriebsparameter des Verstärkers der Lasereinheit 16 abhängt. Vorteilhaft kann einem Betrieb der Lasereinheit außerhalb eines Soll-Grenzwertbereichs durch einen Fehlerfall eines Verstärkers der Lasereinheit entgegengewirkt werden. Vorteilhaft kann ein besonders sicherer Betrieb eines Rotationslasers realisiert werden.

Weiterhin geht die Erfindung aus von einer, insbesondere der zuvor bereits genannten, Regelungs- und Überwachungsvorrichtung für einen, insbesondere den zuvor bereits genannten, Rotationslaser, die zu einer Regelung einer Laserleistung einer, insbesondere der zuvor bereits genannten, Lasereinheit des Rotationslasers in Abhängigkeit von einer Betriebsart eines, insbesondere des zuvor bereits genannten, Rotationskopfs des Rotationslasers eingerichtet ist, insbesondere gemäß einem erfindungsgemäßen Verfahren, mit zumindest einer, insbesondere der zuvor bereits genannten, Steuer- oder Regeleinheit, die dazu eingerichtet ist, die Laserleistung, insbesondere die Soll-Laserleistung, der Lasereinheit in Abhängigkeit von einer Rotationsgeschwindigkeit, insbesondere einer Ist-Rotationsgeschwindigkeit, des Rotationskopfs zu regeln. Es wird vorgeschlagen, dass die Regelungs- und Überwachungsvorrichtung eine, insbesondere die zuvor bereits genannte, weitere Steuer- oder Regeleinheit umfasst, welche dazu eingerichtet ist, insbesondere unabhängig von der Steuer- oder Regeleinheit, die Rotationsgeschwindigkeit, insbesondere die Ist-Rotationsgeschwindigkeit, des Rotationskopfs und zumindest einen Betriebsparameter der Lasereinheit abzufragen und abzugleichen, um ein Signal zu einer Beeinflussung eines mittels der Lasereinheit ausgebbaren Laserstrahls auszugeben, insbesondere um die Lasereinheit zu deaktivieren. Vorzugsweise sind die Steuer- oder Regeleinheit und die weitere Steuer- oder Regeleinheit an, vorzugsweise in, einem gemeinsamen Gehäuse der Regelungs- und Überwachungsvorrichtung angeordnet. Vorteilhaft kann eine Regelungs- und Überwachungsvorrichtung zur Verfügung gestellt werden, die einen besonders sicheren Betrieb einer Lasereinheit eines Rotationslasers unterstützt. Vorteilhaft kann einer Verletzung von Personen in einem Wirkungsbereich des Rotationslasers durch eine zu hohe Laserleistung besonders effizient und zuverlässig entgegengewirkt werden.

Außerdem wird vorgeschlagen, dass die Regelungs- und Überwachungsvorrichtung eine Verbindungseinheit umfasst, die die weitere Steuer- oder Regeleinheit zu einer Abfrage des zumindest einen Betriebsparameters der Lasereinheit steuer- oder regeltechnisch mit der Lasereinheit verbindet. Die Verbindungseinheit ist insbesondere zu einer kabelgebundenen Verbindung der weiteren Steuer- oder Regeleinheit mit der Lasereinheit, insbesondere mit der Treiberschaltung und/oder der Laserdiode, vorgesehen. Die Verbindungseinheit umfasst beispielsweise zumindest ein Verbindungselement, das beispielsweise als Kabel, als Stecker, als Buchse oder dergleichen ausgebildet ist, um eine steuer- oder regeltechnische Verbindung zwischen der weiteren Steuer- oder Regeleinheit und der Lasereinheit herzustellen. Alternativ oder zusätzlich ist auch denkbar, dass die Verbindungseinheit zu einer kabellosen Verbindung der weiteren Steuer- oder Regeleinheit mit der Lasereinheit, insbesondere der Treiberschaltung und/oder der Laserdiode, vorgesehen ist. Beispielsweise ist an der weiteren Steuer- oder Regeleinheit und an der Lasereinheit jeweils ein Transceiver oder dergleichen der Verbindungseinheit angeordnet, die insbesondere dazu vorgesehen sind, zu einer Steuerung oder Regelung der Lasereinheit und/oder zu einer Übertragung des zumindest einen Betriebsparameters der Lasereinheit miteinander zu kommunizieren. Vorteilhaft kann eine Lasereinheit unabhängig von einer Steuer- oder Regeleinheit, die dazu vorgesehen ist, die Lasereinheit zu steuern oder zu regeln, beeinflusst werden, insbesondere bei einem Betrieb der Lasereinheit außerhalb eines Soll-Grenzwertbereichs für die Laserleistung deaktiviert werden. Vorteilhaft kann eine besonders hohe Sicherheit für Personen in einem Wirkungsbereich eines Rotationslasers realisiert werden.

Des Weiteren wird vorgeschlagen, dass die Regelungs- und Überwachungsvorrichtung eine, insbesondere die zuvor bereits genannte, Blockier- und/oder Umlenkeinheit zu einem Blockieren und/oder zu einem Umlenken des mittels der Lasereinheit ausgebbaren Laserstrahls umfasst, die durch das von der weiteren Steuer- oder Regeleinheit ausgebbare Signal aktivierbar ist. Vorteilhaft kann eine besonders hohe Arbeitssicherheit besonders einfach und zuverlässig prüfbar realisiert werden.

Außerdem wird ein, insbesondere der zuvor bereits genannte, Rotationslaser mit zumindest einer, insbesondere der zuvor bereits genannten, Lasereinheit, mit zumindest einem, insbesondere dem zuvor bereits genannten, Rotationskopf, mit zumindest einer, insbesondere der zuvor bereits genannten, Antriebseinheit zu einem Antrieb des Rotationskopfs und mit zumindest einer erfindungsgemäßen Regelungs- oder Überwachungsvorrichtung vorgeschlagen. Vorzugsweise umfasst der Rotationslaser zumindest ein Gehäuse, an, insbesondere in, dem bevorzugt die Lasereinheit, der Rotationskopf und/oder die Antriebseinheit angeordnet sind/ist. Es ist denkbar, dass das Gehäuse des Rotationslasers dem Gehäuse der Regelungs- und Überwachungsvorrichtung entspricht. Alternativ ist auch denkbar, dass das Gehäuse des Rotationslasers verschieden ist von dem Gehäuse der Regelungs- und Überwachungsvorrichtung. Ferner ist denkbar, dass der Rotationslaser eine Nivelliereinheit zu einer Ausrichtung des Rotationskopfs und/oder der Lasereinheit umfasst. Die Nivelliereinheit umfasst vorzugsweise zumindest einen Sensor, beispielsweise einen Beschleunigungssensor oder dergleichen, um eine Lage, vorzugsweise eine Neigung, des Rotationskopfs und/oder der Lasereinheit zu einem Lot zu bestimmen. Die Nivelliereinheit umfasst insbesondere zumindest einen Aktuator, um die Lasereinheit und/oder den Rotationskopf, insbesondere in Abhängigkeit von einer mittels des Sensors bestimmten Lage, vorzugsweise einer Neigung, der Lasereinheit und/oder des Rotationskopfs zum Lot, auszurichten. Vorteilhaft kann ein Rotationslaser zur Verfügung gestellt werden, der einen besonders hohen und verlässlichen Schutz von Personen in einem Wirkungsbereich des Rotationslasers ermöglicht.

Ferner wird vorgeschlagen, dass der Rotationslaser eine, insbesondere die zuvor bereits genannte, Sensoreinheit umfasst, die zumindest zwei, insbesondere voneinander verschiedene, vorzugsweise die zuvor bereits genannten, Bewegungssensoren aufweist, die zu einer Erfassung der Rotationsgeschwindigkeit, insbesondere der Ist-Rotationsgeschwindigkeit, des Rotationskopfs an der Antriebseinheit oder an dem Rotationskopf angeordnet sind. Vorzugsweise entsprechen der zuvor bereits genannte Bewegungssensor und der weitere Bewegungssensor den zwei Bewegungssensoren. Vorteilhaft kann ein Wert für die Rotationsgeschwindigkeit, insbesondere die Ist-Rotationsgeschwindigkeit, besonders zuverlässig überprüft werden. Vorteilhaft kann eine besonders präzise und sichere Steuerung der Lasereinheit in Abhängigkeit von der Rotationsgeschwindigkeit, insbesondere der Ist-Rotationsgeschwindigkeit, des Rotationskopfs erreicht werden.

Das erfindungsgemäße Verfahren, die erfindungsgemäße Regelungs- und Überwachungsvorrichtung und/oder der erfindungsgemäße Rotationslaser sollen/soll hierbei nicht auf die oben beschriebene Anwendung und Ausführungsform beschränkt sein. Insbesondere können/kann das erfindungsgemäße Verfahren, die erfindungsgemäße Regelungs- und Überwachungsvorrichtung und/oder der erfindungsgemäße Rotationslaser zu einer Erfüllung einer hierin beschriebenen Funktionsweise eine von einer hierin genannten Anzahl von einzelnen Elementen, Bauteilen und Einheiten sowie Verfahrensschritten abweichende Anzahl aufweisen. Zudem sollen bei den in dieser Offenbarung angegebenen Wertebereichen auch innerhalb der genannten Grenzen liegende Werte als offenbart und als beliebig einsetzbar gelten.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: einen erfindungsgemäßen Rotationslaser mit einer erfindungsgemäßen Regelungs- und Überwachungsvorrichtung in einer Darstellung,
- Fig. 2: den erfindungsgemäßen Rotationslaser mit der erfindungsgemäßen Regelungs- und Überwachungsvorrichtung und
- Fig. 3: einen schematischen Ablauf eines erfindungsgemäßen Verfahrens zu einem Betrieb der erfindungsgemäßen Regelungs- und Überwach ungsvorrichtu ng.

### Beschreibung des Ausführungsbeispiels

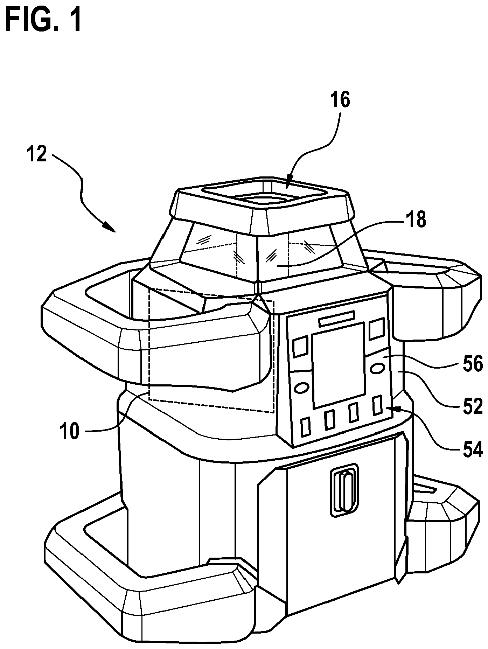

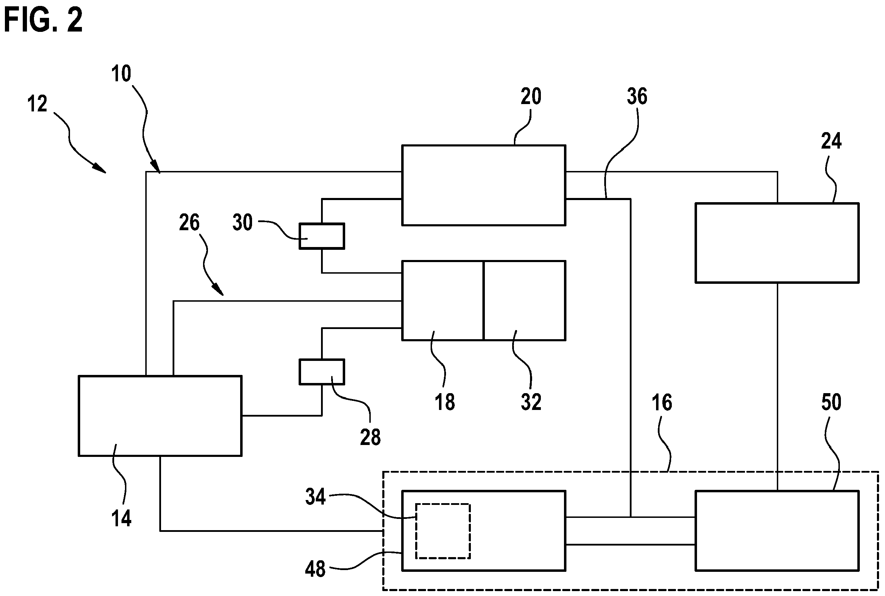

Figur 1 zeigt einen Rotationslaser 12 mit zumindest einer Lasereinheit 16, mit zumindest einem Rotationskopf 18, mit zumindest einer Antriebseinheit 32 zu einem Antrieb des Rotationskopfs 18 und mit zumindest einer Regelungs- und Überwachungsvorrichtung 10. Die Antriebseinheit 32 ist als Elektromotor oder dergleichen ausgebildet. Die Lasereinheit 16 ist an dem Rotationskopf 18 angeordnet. Die Lasereinheit 16 ist derart an dem Rotationskopf 18 angeordnet, dass durch eine Rotation des Rotationskopfs 18 ein mittels der Lasereinheit 16 ausgebbarer Laserstrahl gedreht wird, insbesondere um eine Rotationsachse (hier nicht dargestellt) des Rotationskopfs 18. Der Rotationslaser 12 umfasst zumindest ein Gehäuse 52, an, insbesondere in, dem die Lasereinheit 16, der Rotationskopf 18 und/oder die Antriebseinheit 32 (vgl. Figur 2) angeordnet sind/ist. Der Rotationslaser 12 umfasst eine Nivelliereinheit (hier nicht dargestellt) zu einer Ausrichtung des Rotationskopfs 18 und/oder der Lasereinheit 16. Die Nivelliereinheit umfasst zumindest einen Sensor (hier nicht dargestellt), beispielsweise einen Beschleunigungssensor oder dergleichen, um eine Lage, insbesondere eine Neigung, des Rotationskopfs 18 und/oder der Lasereinheit 16 zu einem Lot zu bestimmen. Die Nivelliereinheit umfasst zumindest einen Aktuator (hier nicht dargestellt), um die Lasereinheit 16 und/oder den Rotationskopf 18, insbesondere in Abhängigkeit von einer mittels des Sensors bestimmten Lage, vorzugsweise einer Neigung, der Lasereinheit 16 und/oder des Rotationskopfs 18 zum Lot, auszurichten.

In Figur 2 ist ein schematischer Aufbau des Rotationslasers 12 und der Regelungs- und Überwachungsvorrichtung 10 gezeigt. Die Regelungs- und Überwachungsvorrichtung 10 ist zu einer Regelung einer Laserleistung der Lasereinheit 16 in Abhängigkeit von einer Betriebsart, insbesondere einer Rotationsgeschwindigkeit, vorzugsweise einer Ist-Rotationsgeschwindigkeit, des Rotationskopfs 18 des Rotationslasers 12 eingerichtet. Die Regelungs- und Überwachungsvorrichtung 10 umfasst zumindest eine Steuer- oder Regeleinheit 14, die dazu eingerichtet ist, die Laserleistung, insbesondere die Soll-Laserleistung, der Lasereinheit 16 in Abhängigkeit von einer Rotationsgeschwindigkeit, insbesondere einer Ist-Rotationsgeschwindigkeit, des Rotationskopfs 18 zu regeln. Die Steuer- oder Regeleinheit 14 umfasst zumindest einen Prozessor (hier nicht dargestellt) und ein Speicherelement (hier nicht dargestellt) sowie ein auf dem Speicherelement gespeichertes Betriebsprogramm. Das Speicherelement ist als digitales Speichermedium, beispielsweise als eine Festplatte oder dergleichen ausgebildet. Die Steuer- oder Regeleinheit 14 ist als Mikrocontroller oder als eine andere, einem Fachmann als sinnvoll erscheinende Steuer- oder Regeleinheit ausgebildet. Die Steuer- oder Regeleinheit 14 ist dazu eingerichtet, die Rotationsgeschwindigkeit des Rotationskopfs 18 zu steuern oder zu regeln, insbesondere durch eine Steuerung oder Regelung der Antriebseinheit 32. Beispielsweise umfasst der Rotationslaser 12 oder die Steuerungs- und Überwachungsvorrichtung 10 eine Eingabeeinheit 54, die steuer- oder regeltechnisch, vorzugsweise datentechnisch, insbesondere kabelgebunden, mit der Steuer- oder Regeleinheit 14 verbunden ist. Alternativ ist auch denkbar, dass die Eingabeeinheit 54 kabellos mit der Steuer- oder Regeleinheit 14 steuer- oder regeltechnisch verbunden ist. Die Eingabeeinheit 54 umfasst zumindest ein Tastenfeld 56. Alternativ ist auch denkbar, dass die Eingabeeinheit 54 einen Drehregler, ein Touchscreen, einen Schieberegler, eine Fernbedienung oder dergleichen umfasst. Über die Eingabeeinheit 54 ist durch einen Nutzer eine Rotationsgeschwindigkeit, insbesondere eine Soll-Rotationsgeschwindigkeit, für den Rotationskopf 18 eingebbar. Es ist auch denkbar, dass die Rotationsgeschwindigkeit automatisch geregelt ist.

Die Steuer- oder Regeleinheit 14 ist dazu eingerichtet, die Rotationsgeschwindigkeit, insbesondere die Ist-Rotationsgeschwindigkeit, des Rotationskopfs 18 abzufragen und/oder zu ermitteln. Es ist denkbar, dass die Steuer- oder Regeleinheit 14 dazu eingerichtet ist, die Rotationsgeschwindigkeit, insbesondere die Ist-Rotationsgeschwindigkeit, des Rotationskopfs 18 direkt am Rotationskopf 18 abzufragen und/oder zu ermitteln oder in Abhängigkeit von einer mittels der Steuer- oder Regeleinheit 14 abgefragten Rotationsgeschwindigkeit, insbesondere einer Ist-Rotationsgeschwindigkeit, der Antriebseinheit 32 zu ermitteln. In Abhängigkeit von einer Rotationsgeschwindigkeit, insbesondere einer Ist-Rotationsgeschwindigkeit, des Rotationskopfs 18, insbesondere in Abhängigkeit von einer Rotationsgeschwindigkeit, insbesondere einer Ist-Rotationsgeschwindigkeit, der Antriebseinheit 32, ist eine Betriebsart des Rotationskopfs 18 bestimmbar. Die Betriebsart des Rotationskopfs 18 kann ein Stillstand des Rotationskopfs 18, eine Rotation des Rotationskopfs 18 mit unterschiedlichen Rotationsgeschwindigkeiten, beispielsweise 150 U/min, 300 U/min, 600 U/min, 1200 U/min oder andere, einem Fachmann also sinnvoll erscheinende Rotationsgeschwindigkeiten, eine Rotationsrichtung einer Rotation des Rotationskopfs 18 oder dergleichen sein. Die Steuer- oder Regeleinheit 14 ist dazu eingerichtet, in Abhängigkeit von der ermittelten Rotationsgeschwindigkeit, insbesondere der Ist-Rotationsgeschwindigkeit, vorzugsweise der ermittelten Betriebsart, des Rotationskopfs 18 eine Laserleistung, insbesondere eine Soll-Laserleistung, der Lasereinheit 16 einzustellen. Alternativ ist auch denkbar, dass die Steuer- oder Regeleinheit 14 dazu eingerichtet ist, die Laserleistung, insbesondere die Soll-Laserleistung, direkt in Abhängigkeit von einer vorgenommenen Einstellung für die Rotationsgeschwindigkeit, insbesondere der Soll-Rotationsgeschwindigkeit, des Rotationskopfs 18 einzustellen.

Der Rotationslaser 12 umfasst zumindest eine Sensoreinheit 26 die zumindest zwei, insbesondere voneinander verschiedene, Bewegungssensoren 28, 30 aufweist, die zu einer Erfassung einer Rotationsgeschwindigkeit, insbesondere einer Ist-Rotationsgeschwindigkeit, des Rotationskopfs 18 an der Antriebseinheit 32 oder an dem Rotationskopf 18 angeordnet sind. Die Steuer- oder Regeleinheit 14 ist dazu eingerichtet, ein Sensorsignal eines Bewegungssensors 28 der zwei Bewegungssensoren 28, 30 abzufragen, wobei die Betriebsart, insbesondere eine durch eine Rotationsgeschwindigkeit und/oder durch eine Rotationsrichtung definierte Betriebsart, des Rotationskopfs 18, in Abhängigkeit von einer Auswertung einer zeitlichen Änderung des durch die Steuer- oder Regeleinheit 14 abgefragten Sensorsignals des Bewegungssensors 28 durch die Steuer- oder Regeleinheit 14 ermittelbar ist.

Die Steuer- oder Regeleinheit 14 ist dazu eingerichtet, eine Laserleistung, insbesondere eine Soll-Laserleistung, der Lasereinheit 16 in Abhängigkeit von der ermittelten Rotationsgeschwindigkeit, insbesondere der Ist-Rotationsgeschwindigkeit, des Rotationskopfs 18 derart einzustellen, dass ein maximaler Wert der Laserleistung innerhalb eines Soll-Grenzwertbereichs, der beispielsweise auf dem Speicherelement der Steuer- oder Regeleinheit 14 hinterlegt ist, für die Laserleistung bei der entsprechenden Rotationsgeschwindigkeit, insbesondere der Ist-Rotationsgeschwindigkeit, des Rotationskopfs 18 liegt. Der Soll-Grenzwertbereich für die Laserleistung ist abhängig von einer Rotationsgeschwindigkeit, insbesondere einer Ist-Rotationsgeschwindigkeit, des Rotationskopfs 18, insbesondere von der Betriebsart des Rotationskopfs 18. Der Soll-Grenzwertbereich ist beispielsweise durch Sicherheitsbestimmungen zu einem Betrieb eines Lasers vorgegeben. Die Lasereinheit 16 umfasst zumindest eine Laserdiode 50. Die Lasereinheit 16 umfasst zumindest eine Treiberschaltung 48 zu einer Anregung der Laserdiode 50. Die Treiberschaltung 48 ist zu einer elektrischen Anregung der Laserdiode 50 eingerichtet. Alternativ ist denkbar, dass die Treiberschaltung 48 zu einem optischen Pumpen der Laserdiode 50 eingerichtet ist. Alternativ ist auch denkbar, dass die Lasereinheit 16 einen Gaslaser, einen Farbstofflaser, oder einen von der Laserdiode 50 verschiedenen Festkörperlaser umfasst. Die Treiberschaltung 48 ist verschieden von der Steuer- oder Regeleinheit 14 ausgebildet. Alternativ ist auch denkbar, dass die Treiberschaltung 48 in die Steuer- oder Regeleinheit 14 integriert ist, insbesondere die Treiberschaltung 48 und die Steuer- oder Regeleinheit 14 auf einer gemeinsamen Platine angeordnet sind. Ferner ist denkbar, dass die Lasereinheit 16 zumindest ein Laserleistungsmesselement (hier nicht dargestellt) zu einer Erfassung einer Laserleistung, insbesondere einer Ist-Laserleistung, eines mittels der Lasereinheit 16 ausgebbaren Laserstrahls umfasst. Das Laserleistungsmesselement ist beispielsweise als Diode ausgebildet. Beispielsweise ist mittels des als Diode ausgebildeten Laserleistungsmesselements eine Laserleistung, insbesondere eine Ist-Laserleistung, des mittels der Lasereinheit 16 ausgebbaren Laserstrahls über einen damit in der Diode erzeugten Photostrom ermittelbar. Es ist denkbar, dass die Steuer- oder Regeleinheit 14 dazu eingerichtet ist, die Laserleistung, insbesondere die Soll-Laserleistung, der Lasereinheit 16 in Abhängigkeit von der mittels des Laserleistungsmesselements erfassten Laserleistung, insbesondere der Ist-Laserleistung, der Lasereinheit 16 zu regeln.

Die Regelungs- und Überwachungsvorrichtung 10 umfasst zumindest eine weitere Steuer- oder Regeleinheit 20. Die weitere Steuer- oder Regeleinheit 20 ist als Mikrocontroller oder als eine andere, einem Fachmann als sinnvoll erscheinende Steuer- oder Regeleinheit ausgebildet. Die weitere Steuer- oder Regeleinheit 20 ist dazu eingerichtet, insbesondere unabhängig von der Steuer- oder Regeleinheit 14, die Rotationsgeschwindigkeit, insbesondere die Ist-Rotationsgeschwindigkeit, des Rotationskopfs 18 und zumindest einen Betriebsparameter der Lasereinheit 16 abzufragen und abzugleichen, um ein Signal zu einer Beeinflussung eines mittels der Lasereinheit 16 ausgebbaren Laserstrahls auszugeben, insbesondere um die Lasereinheit 16 zu deaktivieren. Die Steuer- oder Regeleinheit 14 und die weitere Steuer- oder Regeleinheit 20 sind in dem Gehäuse 52 des Rotationslasers 12 angeordnet. Die weitere Steuer- oder Regeleinheit 20 ist verschieden von der Steuer- oder Regeleinheit 14 ausgebildet. Alternativ ist auch denkbar, dass die Steuer- oder Regeleinheit 14 und die weitere Steuer- oder Regeleinheit 20 auf einer gemeinsamen Platine angeordnet sind. Die Steuer- oder Regeleinheit 14 und die weitere Steuer- oder Regeleinheit 20 weisen voneinander verschiedene Betriebsprogramme auf. Die weitere Steuer- oder Regeleinheit 20 ist dazu vorgesehen, die Rotationsgeschwindigkeit, insbesondere die Ist-Rotationsgeschwindigkeit, des Rotationskopfs 18 abzufragen und/oder zu ermitteln. Es ist denkbar, dass die weitere Steuer- oder Regeleinheit 20 dazu eingerichtet ist, die Rotationsgeschwindigkeit, insbesondere die Ist-Rotationsgeschwindigkeit, des Rotationskopfs 18 direkt an dem Rotationskopf 18 abzufragen oder in Abhängigkeit von einer Abfrage der Rotationsgeschwindigkeit, insbesondere der Ist-Rotationsgeschwindigkeit, der Antriebseinheit 32 mittels der weiteren Steuer- oder Regeleinheit 20 zu ermitteln. Die weitere Steuer- oder Regeleinheit 20 ist dazu eingerichtet, die Rotationsgeschwindigkeit, insbesondere die Ist-Rotationsgeschwindigkeit, des Rotationskopfs 18 unabhängig von der Steuer- oder Regeleinheit 14 zu ermitteln. Die weitere Steuer- oder Regeleinheit 20 ist dazu eingerichtet, ein Sensorsignal eines weiteren Bewegungssensors 30 der zwei Bewegungssensoren 28, 30 abzufragen, wobei die Betriebsart, insbesondere eine durch eine Rotationsgeschwindigkeit, insbesondere eine Ist-Rotationsgeschwindigkeit, und/oder durch eine Rotationsrichtung definierte Betriebsart, des Rotationskopfs 18 in Abhängigkeit von einer Auswertung einer zeitlichen Änderung des durch die weitere Steuer- oder Regeleinheit 20 abgefragten Sensorsignals des weiteren Bewegungssensors 30 durch die weitere Steuer- oder Regeleinheit 20 ermittelbar ist. Der Bewegungssensor 28 ist verschieden von dem weiteren Bewegungssensor 30 ausgebildet. Der Bewegungssensor 28 und der weitere Bewegungssensor 30 basieren auf voneinander verschiedenen Messmethoden zu einer Erfassung einer Rotationsgeschwindigkeit, insbesondere einer Ist-Rotationsgeschwindigkeit. Alternativ ist auch denkbar, dass der Bewegungssensor 28 und der weitere Bewegungssensor 30 identisch ausgebildet sind, insbesondere auf identischen Messmethoden zu einer Erfassung einer Rotationsgeschwindigkeit, insbesondere einer Ist-Rotationsgeschwindigkeit, basieren. Der Bewegungssensor 28 und/oder der weitere Bewegungssensor 30 sind/ist beispielsweise als optische Encoder, als Magnetfeldsensor/en oder dergleichen ausgebildet. Alternativ ist auch denkbar, dass der Bewegungssensor 28 und/oder der weitere Bewegungssensor 30 als Akustiksensor/en oder als andere/r, einem Fachmann als sinnvoll erscheinende Sensor/en zur Erfassung einer Rotationsgeschwindigkeit, insbesondere einer Ist-Rotationsgeschwindigkeit, ausgebildet sind/ist. Die Sensoreinheit 26, insbesondere der Bewegungssensor 28 und/oder der weitere Bewegungssensor 30, sind/ist an der Antriebseinheit 32 und/oder an dem Rotationskopf 18 angeordnet.

Die weitere Steuer- oder Regeleinheit 20 ist steuer- oder regeltechnisch, vorzugsweise datentechnisch, kabellos oder kabelgebunden, mit der Lasereinheit 16 verbunden. Die Regelungs- und Überwachungsvorrichtung 10 umfasst zumindest eine Verbindungseinheit 36, die die weitere Steuer- oder Regeleinheit 20 zu einer Abfrage des zumindest einen Betriebsparameters der Lasereinheit 16 steuer- oder regeltechnisch mit der Lasereinheit 16 verbindet. Die Verbindungseinheit 36 ist zu einer kabelgebundenen Verbindung der weiteren Steuer- oder Regeleinheit 20 mit der Lasereinheit 16, insbesondere mit der Treiberschaltung 48 und/oder der Laserdiode 50, vorgesehen. Die Verbindungseinheit 36 umfasst zumindest ein Verbindungselement, das beispielsweise als Kabel, als Stecker, als Buchse oder dergleichen ausgebildet ist, um eine steuer- oder regeltechnische Verbindung zwischen der weiteren Steuer- oder Regeleinheit 20 und der Lasereinheit 16 herzustellen. Alternativ oder zusätzlich ist auch denkbar, dass die Verbindungseinheit 36 zu einer kabellosen Verbindung der weiteren Steuer- oder Regeleinheit 20 mit der Lasereinheit 16, insbesondere der Treiberschaltung 48 und/oder der Laserdiode 50, vorgesehen ist. Beispielsweise ist an der weiteren Steuer- oder Regeleinheit 20 und an der Lasereinheit 16 jeweils ein Transceiver oder dergleichen der Verbindungseinheit 36 angeordnet, die insbesondere dazu vorgesehen sind, zu einer Steuerung oder Regelung der Lasereinheit 16 und/oder zu einer Übertragung des zumindest einen Betriebsparameters der Lasereinheit 16 miteinander zu kommunizieren.

Die weitere Steuer- oder Regeleinheit 20 ist dazu vorgesehen, in Abhängigkeit von dem zumindest einen Betriebsparameter der Lasereinheit 16 eine Laserleistung, insbesondere eine Soll-Laserleistung und/oder eine Ist-Laserleistung, der Lasereinheit 16 zu ermitteln. Die weitere Steuer- oder Regeleinheit 20 ist dazu vorgesehen, die mittels der weiteren Steuer- oder Regeleinheit 20 abgefragte und/oder ermittelte Laserleistung, insbesondere die Soll-Laserleistung und/oder die Ist-Laserleistung, der Lasereinheit 16 mit der mittels der weiteren Steuer- oder Regeleinheit 20 abgefragten und/oder ermittelten Rotationsgeschwindigkeit, insbesondere der Ist-Rotationsgeschwindigkeit, des Rotationskopfs 18 abzugleichen. Die weitere Steuer- oder Regeleinheit 20 ist dazu vorgesehen, zu prüfen ob ein maximaler Wert der mittels der weiteren Steuer- oder Regeleinheit 20 abgefragten und/oder ermittelten Laserleistung, insbesondere der Soll-Laserleistung und/oder der Ist-Laserleistung, der Lasereinheit 16 innerhalb des Soll-Grenzwertbereichs, der insbesondere auf einem Speicherelement (hier nicht dargestellt) der weiteren Steuer- oder Regeleinheit 20 hinterlegt ist, für die Laserleistung bei der entsprechenden Rotationsgeschwindigkeit, insbesondere der Ist-Rotationsgeschwindigkeit, des Rotationskopfs 18 liegt. Die weitere Steuer- oder Regeleinheit 20 ist dazu vorgesehen, das Signal zu einer Beeinflussung eines mittels der Lasereinheit 16 ausgebbaren Laserstrahls auszugeben, wenn ein mittels der weiteren Steuer- oder Regeleinheit 20 ermittelter maximaler Wert der Laserleistung, insbesondere der Soll-Laserleistung und/oder der Ist-Laserleistung, des mittels der Lasereinheit 16 ausgebbaren Laserstrahls außerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt.

Der zumindest eine Betriebsparameter der Lasereinheit 16 ist als eine von der Steuer- oder Regeleinheit 14 vorgenommene Laserleistungseinstellung, insbesondere eine Soll-Laserleistung, oder als eine von der Lasereinheit 16 ausgebbare Laserleistung, insbesondere eine Ist-Laserleistung, ausgebildet. Alternativ oder zusätzlich ist auch denkbar, dass der zumindest eine Betriebsparameter ein tatsächlicher Betriebsparameter der Lasereinheit 16 oder dergleichen ist. Es ist denkbar, dass die weitere Steuer- oder Regeleinheit 20 dazu vorgesehen ist, die mittels des Laserleistungsmesselements erfasste Laserleistung, insbesondere die Ist-Laserleistung, des mittels der Lasereinheit 16 ausgebbaren Laserstrahls abzufragen. Zusätzlich oder alternativ ist auch denkbar, dass die weitere Steuer- oder Regeleinheit 20 ein weiteres Laserleistungsmesselement (hier nicht dargestellt), beispielsweise eine weitere Diode oder dergleichen, zu einer Erfassung einer Laserleistung, insbesondere einer Ist-Laserleistung, eines mittels der Lasereinheit 16 ausgebbaren Laserstrahls umfasst. Die von der Steuer- oder Regeleinheit 14 vorgenommene Laserleistungseinstellung ist beispielsweise eine Steuer- oder Regelspannung, eine digitale Steuer- oder Regelinformation oder dergleichen.

Das Signal zu einer Beeinflussung eines mittels der Lasereinheit 16 ausgebbaren Laserstrahls ist ein Signal zu einer Steuerung oder Regelung der Lasereinheit 16, insbesondere der Treiberschaltung 48 der Lasereinheit 16 und/oder ein Signal zu einer direkten Einflussnahme auf den mittels der Lasereinheit 16 ausgebbaren Laserstrahl. Ein Signal zu einer direkten Einflussnahme auf einen mittels der Lasereinheit 16 ausgebbaren Laserstrahl ist ein Signal zu einer Aktivierung einer Blockier- und/oder Umlenkeinheit 24 der Regelungs- und Überwachungsvorrichtung 10 zu einem Blockieren und/oder Umlenken des Laserstrahls oder dergleichen. Alternativ oder zusätzlich ist auch denkbar, dass das Signal zu einer Beeinflussung eines mittels der Lasereinheit 16 ausgebbaren Laserstrahls ein Signal zu einer Steuerung oder Regelung einer Stromversorgung (hier nicht dargestellt) der Lasereinheit 16 und/oder der Laserdiode 50 ist. Das Signal zu einer Beeinflussung des mittels der Lasereinheit 16 ausgebbaren Laserstrahls ist dazu vorgesehen, eine Laserleistung, insbesondere eine Soll-Laserleistung und/oder eine Ist-Laserleistung, der Lasereinheit 16 zu ändern, vorzugsweise zu verringern, die Lasereinheit 16 abzuschalten und/oder einer Ausbreitung des mittels der Lasereinheit 16 ausgebbaren Laserstrahls entgegenzuwirken. Das Signal zu einer Beeinflussung des mittels der Lasereinheit 16 ausgebbaren Laserstrahls ist dazu vorgesehen, die Laserleistung, insbesondere die Soll-Laserleistung und/oder eine Ist-Laserleistung, derart zu ändern, vorzugsweise zu verringern, alternativ oder zusätzlich zu erhöhen, dass ein maximaler Wert der Laserleistung, insbesondere der Ist-Laserleistung, innerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt. Es ist denkbar, dass die weitere Steuer- oder Regeleinheit 20 dazu vorgesehen ist, das Signal zu einer Beeinflussung eines mittels der Lasereinheit 16 ausgebbaren Laserstrahls in Abhängigkeit von lediglich einem Betriebsparameter der Lasereinheit 16 oder von mehreren Betriebsparametern der Lasereinheit 16 auszugeben.

Die Regelungs- und Überwachungsvorrichtung 10 umfasst zumindest die Blockier- und/oder Umlenkeinheit 24 zu einem Blockieren und/oder zu einem Umlenken des mittels der Lasereinheit 16 ausgebbaren Laserstrahls, die durch das von der weiteren Steuer- oder Regeleinheit 20 ausgebbare Signal aktivierbar ist. Die weitere Steuer- oder Regeleinheit 20 ist steuer- oder regeltechnisch, insbesondere datentechnisch, beispielsweise kabellos oder kabelgebunden, mit der Blockier- und/oder Umlenkeinheit 24 verbunden, bevorzugt um das Signal zu einer Beeinflussung des mittels der Lasereinheit 16 ausgebbaren Laserstrahls zu einer Ansteuerung oder Regelung der Blockier- und/oder Umlenkeinheit 24 an die Blockier- und/oder Umlenkeinheit 24 zu übertragen. Die Blockier- und/oder Umlenkeinheit 24 umfasst zumindest ein Blockierelement (hier nicht dargestellt) und/oder zumindest ein Umlenkelement (hier nicht dargestellt). Das Blockierelement ist beispielsweise als eine Klappe, als eine Blende oder als ein anderes, einem Fachmann als sinnvoll erscheinendes Element zu einem Blockieren eines Laserstrahls ausgebildet. Das Umlenkelement ist beispielsweise als ein Spiegel, als ein Prisma oder als eine anderes, einem Fachmann als sinnvoll erscheinendes Element zu einem Umlenken eines Laserstrahls ausgebildet. Die Blockier- und/oder Umlenkeinheit 24 ist dazu vorgesehen, den mittels der Lasereinheit 16 ausgebbaren Laserstrahl, insbesondere mittels des zumindest einen Umlenkelements und/oder des zumindest einen Blockierelements, in einem aktivierten Zustand der Blockier- und/oder Umlenkeinheit 24 derart zu blockieren und/oder umzulenken, dass der Laserstrahl von einer Ausstrahlung an eine Umgebung des Rotationslasers 12 gehindert wird. Die Blockier- und/oder Umlenkeinheit 24, insbesondere das zumindest eine Blockierelement und/oder das zumindest eine Umlenkelement, sind an der Lasereinheit 16, vorzugsweise an der Laserdiode 50 der Lasereinheit 16, angeordnet. Es ist auch denkbar, dass die Regelungs- und Überwachungsvorrichtung 10 frei von einer Blockier- und/oder Umlenkeinheit 24 ausgebildet ist.

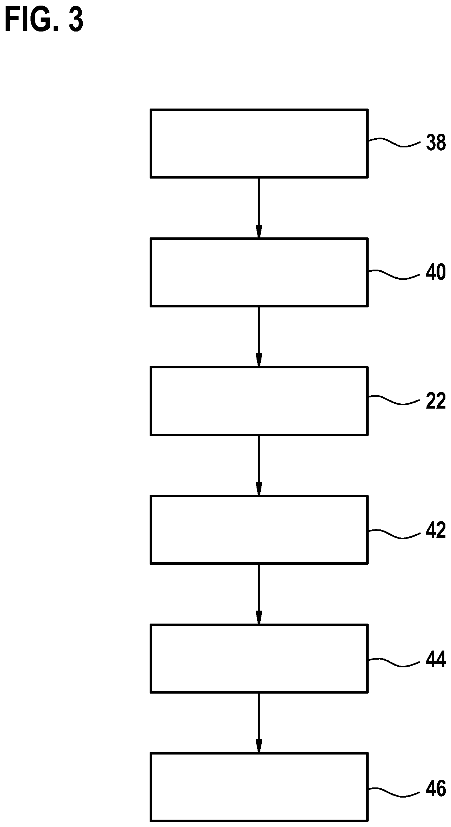

Figur 3 zeigt einen schematischen Ablauf eines Verfahrens zu einem Betrieb der Regelungs- und Überwachungsvorrichtung 10 für den Rotationslaser 12. Mittels der Steuer- oder Regeleinheit 14 wird, insbesondere in einem Verfahrensschritt 38, die Rotationsgeschwindigkeit, insbesondere die Soll-Rotationsgeschwindigkeit, des Rotationskopfs 18 gesteuert oder geregelt, bevorzugt über eine Steuerung oder Regelung der Antriebseinheit 32 durch die Steuer- oder Regeleinheit 14. Eine Rotationsgeschwindigkeit, insbesondere eine Soll-Rotationsgeschwindigkeit, des Rotationskopfs 18 wird über die Eingabeeinheit 54 eingestellt. Beispielsweise wird eine Rotationsgeschwindigkeit, insbesondere eine Soll-Rotationsgeschwindigkeit, des Rotationskopfs 18 durch eine Eingabe eines Nutzers über die Eingabeeinheit 54 eingestellt. Es ist alternativ auch denkbar, dass die Rotationsgeschwindigkeit des Rotationskopfs 18 automatisch eingestellt wird. Mittels der Steuer- oder Regeleinheit 14 wird, insbesondere in einem weiteren Verfahrensschritt 40, die Rotationsgeschwindigkeit, insbesondere die Ist-Rotationsgeschwindigkeit, des Rotationskopfs 18 abgefragt und/oder ermittelt.

In einem Verfahrensschritt 22 wird mittels der Steuer- oder Regeleinheit 14 eine Laserleistung, insbesondere eine Soll-Laserleistung, der Lasereinheit 16 in Abhängigkeit von einer Rotationsgeschwindigkeit, insbesondere einer Ist-Rotationsgeschwindigkeit, des Rotationskopfs 18 geregelt. In Abhängigkeit von der ermittelten Rotationsgeschwindigkeit, insbesondere der Ist-Rotationsgeschwindigkeit, vorzugsweise der ermittelten Betriebsart, des Rotationskopfs 18 wird mittels der Steuer- oder Regeleinheit 14 eine Laserleistung, insbesondere eine Soll-Laserleistung, der Lasereinheit 16 eingestellt. Alternativ ist auch denkbar, dass die Laserleistung, insbesondere eine Soll-Laserleistung, der Lasereinheit 16 mittels der Steuer- oder Regeleinheit 14 direkt in Abhängigkeit von einer vorgenommenen Einstellung für die Rotationsgeschwindigkeit, insbesondere der Soll-Rotationsgeschwindigkeit, des Rotationskopfs 18 eingestellt wird. Die Laserleistung, insbesondere die Soll-Laserleistung, der Lasereinheit 16 wird mittels der Steuer- oder Regeleinheit 14 in Abhängigkeit von der ermittelten Rotationsgeschwindigkeit, insbesondere der Ist-Rotationsgeschwindigkeit, des Rotationskopfs 18 derart eingestellt, dass ein maximaler Wert der Laserleistung innerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt. Es ist zusätzlich oder alternativ denkbar, dass die Steuer- oder Regeleinheit 14 die Laserleistung, insbesondere die Soll-Laserleistung, der Lasereinheit 16 in Abhängigkeit von der mittels des Laserleistungsmesselements erfassten Laserleistung, insbesondere der Ist-Laserleistung, der Lasereinheit 16 regelt.

Mittels der weiteren Steuer- oder Regeleinheit 20 wird die Rotationsgeschwindigkeit, insbesondere die Ist-Rotationsgeschwindigkeit, des Rotationskopfs 18 und zumindest ein Betriebsparameter der Lasereinheit 16 abgefragt und abgeglichen, um das Signal zu einer Beeinflussung eines mittels der Lasereinheit 16 ausgebbaren Laserstrahls auszugeben. Mittels der Steuer- oder Regeleinheit 14 wird ein Sensorsignal des Bewegungssensors 28 der Sensoreinheit 26, insbesondere in dem Verfahrensschritt 40, und mittels der weiteren Steuer- oder Regeleinheit 20, insbesondere in einem Verfahrensschritt 42 ein Sensorsignal des weiteren Bewegungssensors 30 der Sensoreinheit 26 abgefragt, wobei eine Betriebsart, insbesondere eine durch eine Rotationsgeschwindigkeit und/oder durch eine Rotationsrichtung definierte Betriebsart, des Rotationskopfs 18 in Abhängigkeit von einer Auswertung einer zeitlichen Änderung des durch die Steuer- oder Regeleinheit 14, insbesondere in dem Verfahrensschritt 40, abgefragten Sensorsignals des Bewegungssensors 28 und des durch die weitere Steuer- oder Regeleinheit 20, insbesondere in dem Verfahrensschritt 42, abgefragten Sensorsignals des weiteren Bewegungssensors 30 ermittelt wird. Mittels der weiteren Steuer- oder Regeleinheit 20 wird die Rotationsgeschwindigkeit, insbesondere die Ist-Rotationsgeschwindigkeit, des Rotationskopfs 18 unabhängig von der Steuer- oder Regeleinheit 14 ermittelt. Die Betriebsart, insbesondere die Rotationsgeschwindigkeit, vorzugsweise die Ist-Rotationsgeschwindigkeit, des Rotationskopfs 18 wird in Abhängigkeit von einer Auswertung einer zeitlichen Änderung des durch die Steuer- oder Regeleinheit 14 abgefragten Sensorsignals des Bewegungssensors 28 unabhängig von einer Ermittlung der Betriebsart, insbesondere der Rotationsgeschwindigkeit, des Rotationskopfs 18 in Abhängigkeit von einer Auswertung einer zeitlichen Änderung des durch die weitere Steuer- oder Regeleinheit 20 abgefragten Sensorsignals des weiteren Bewegungssensors 30 ermittelt.

Mittels der weiteren Steuer- oder Regeleinheit 20 wird ein als eine von der Steuer- oder Regeleinheit 14 vorgenommene Laserleistungseinstellung, insbesondere eine Soll-Laserleistung, oder ein als eine von der Lasereinheit 16 ausgebbare Laserleistung, insbesondere eine Ist-Laserleistung, ausgebildeter Betriebsparameter der Lasereinheit 16 abgefragt. Mittels der weiteren Steuer- oder Regeleinheit 20 wird, insbesondere in einem Verfahrensschritt 44, in Abhängigkeit von dem zumindest einen Betriebsparameter der Lasereinheit 16 eine Laserleistung, insbesondere eine Soll-Laserleistung und/oder eine Ist-Laserleistung, der Lasereinheit 16 ermittelt. Die weitere Steuer- oder Regeleinheit 20 gleicht die mittels der weiteren Steuer- oder Regeleinheit 20 abgefragte und/oder ermittelte Laserleistung, insbesondere die Soll-Laserleistung und/oder die Ist-Laserleistung, der Lasereinheit 16 mit der mittels der weiteren Steuer- oder Regeleinheit 20 abgefragten und/oder ermittelten Rotationsgeschwindigkeit, insbesondere der Ist-Rotationsgeschwindigkeit, des Rotationskopfs 18 ab. Mittels der weiteren Steuer- oder Regeleinheit 20 wird geprüft, ob ein maximaler Wert der mittels der weiteren Steuer- oder Regeleinheit 20 abgefragten und/oder ermittelten Laserleistung, insbesondere der Soll-Laserleistung und/oder der Ist-Laserleistung, der Lasereinheit 16 innerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt. Das Signal zu einer Beeinflussung eines mittels der Lasereinheit 16 ausgebbaren Laserstrahls wird mittels der weiteren Steuer- oder Regeleinheit 20, insbesondere in einem Verfahrensschritt 46, ausgegeben, wenn ein mittels der weiteren Steuer- oder Regeleinheit 20 ermittelter maximaler Wert der Laserleistung, insbesondere der Soll-Laserleistung und/oder der Ist-Laserleistung, des mittels der Lasereinheit 16 ausgebbaren Laserstrahls außerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt. Mittels des Signals zu einer Beeinflussung eines mittels der Lasereinheit 16 ausgebbaren Laserstrahls wird eine Laserleistung, insbesondere eine Soll-Laserleistung und/oder eine Ist-Laserleistung, der Lasereinheit 16 geändert, vorzugsweise verringert, die Lasereinheit 16 deaktiviert und/oder einer Ausbreitung des mittels der Lasereinheit 16 ausgebbaren Laserstrahls entgegengewirkt. Mittels des Signals zu einer Beeinflussung des mittels der Lasereinheit 16 ausgebbaren Laserstrahls wird die Laserleistung, insbesondere die Soll-Laserleistung und/oder Ist-Laserleistung, derart geändert, beispielsweise verringert oder erhöht, dass ein maximaler Wert der Laserleistung, insbesondere der Ist-Laserleistung, innerhalb des Soll-Grenzwertbereichs für die Laserleistung bei der entsprechenden Rotationsgeschwindigkeit, insbesondere der Ist-Rotationsgeschwindigkeit, des Rotationskopfs 18 liegt.

Alternativ oder zusätzlich wird die Blockier- und/oder Umlenkeinheit 24 zu einem Blockieren und/oder Umlenken des mittels der Lasereinheit 16 ausgebbaren Laserstrahls, insbesondere in dem Verfahrensschritt 46, in Abhängigkeit von dem mittels der weiteren Steuer- oder Regeleinheit 20 ausgebbaren Signal aktiviert. Beispielsweise wird in Abhängigkeit von dem mittels der weiteren Steuer- oder Regeleinheit 20 ausgebbaren Signal zu einer Beeinflussung des mittels der Lasereinheit 16 ausgebbaren Laserstrahls das zumindest eine Blockierelement in einen Strahlengang des mittels der Lasereinheit 16 ausgebbaren Laserstrahls gebracht, um den Laserstrahl zu blockieren. Beispielsweise wird alternativ oder zusätzlich in Abhängigkeit von dem mittels der weiteren Steuer- oder Regeleinheit 20 ausgebbaren Signal zu einer Beeinflussung des mittels der Lasereinheit 16 ausgebbaren Laserstrahls das zumindest eine Umlenkelement in den Strahlengang des mittels der Lasereinheit 16 ausgebbaren Laserstrahls gebracht, um den Laserstrahl umzulenken.

Alternativ oder zusätzlich wird, insbesondere in dem Verfahrensschritt 44, mittels der weiteren Steuer- oder Regeleinheit 20 zumindest ein Betriebsparameter, insbesondere ein Ist-Betriebsparameter, der Steuer- oder Regeleinheit 14 abgefragt, um zumindest in Abhängigkeit von dem zumindest einen Betriebsparameter, insbesondere dem Ist-Betriebsparameter, der Steuer- oder Regeleinheit 14 das Signal zu einer Beeinflussung des mittels der Lasereinheit 16 ausgebbaren Laserstrahls mittels der weiteren Steuer- oder Regeleinheit 20 auszugeben. Es ist denkbar, dass das Signal zu einer Beeinflussung eines mittels der Lasereinheit 16 ausgebbaren Laserstrahls von dem zumindest einen Betriebsparameter der Lasereinheit 16 zusätzlich oder alternativ von dem zumindest einen Betriebsparameter der Steuer- oder Regeleinheit 14 abhängt. Der zumindest eine Betriebsparameter der Steuer- oder Regeleinheit 14 ist ein die Laserleistung, insbesondere die Ist-Laserleistung, beeinflussender Betriebsparameter, insbesondere ein Ist-Betriebsparameter, der Steuer- oder Regeleinheit 14. Ferner ist auch denkbar, dass das Signal zu einer Beeinflussung eines mittels der Lasereinheit 16 ausgebbaren Laserstrahls alternativ oder zusätzlich von zumindest einem weiteren Betriebsparameter, insbesondere einem Ist-Betriebsparameter, eines weiteren Bauteils der Regelungs- und Überwachungsvorrichtung 10 und/oder eines weiteren Bauteils des Rotationslasers 12, wobei der weitere Betriebsparameter insbesondere Einfluss auf eine mittels der Lasereinheit 16 ausgebbare Laserleistung, insbesondere die Ist-Laserleistung, hat, abhängt, beispielsweise ein Betriebsparameter einer Spannungsversorgung oder dergleichen.

Ferner wird alternativ oder zusätzlich mittels der weiteren Steuer- oder Regeleinheit 20 zumindest ein Betriebsparameter, insbesondere eine Spannungskenngröße, eines Verstärkers 34, insbesondere eines Operationsverstärkers, der Lasereinheit 16 abgefragt, um zumindest in Abhängigkeit von dem zumindest einen Betriebsparameter des Verstärkers 34 das Signal zu einer Beeinflussung des mittels der Lasereinheit 16 ausgebbaren Laserstrahls mittels der weiteren Steuer- oder Regeleinheit 20 auszugeben. Es ist denkbar, dass das Signal zu einer Beeinflussung eines mittels der Lasereinheit 16 ausgebbaren Laserstrahls von dem als eine von der Steuer- oder Regeleinheit 14 vorgenommene Laserleistungseinstellung, insbesondere eine Soll-Laserleistung, oder als eine von der Lasereinheit 16 ausgebbare Laserleistung, insbesondere die Ist-Laserleistung, ausgebildeter Betriebsparameter der Lasereinheit 16 zusätzlich oder alternativ von dem zumindest einen Betriebsparameter des Verstärkers 34 und/oder von dem zumindest einen Betriebsparameter der Steuer- oder Regeleinheit 14 abhängt. Es ist auch denkbar, dass das Signal zu einer Beeinflussung des mittels der Lasereinheit 16 ausgebbaren Signals lediglich in Abhängigkeit von dem als eine von der Steuer- oder Regeleinheit 14 vorgenommene Laserleistungseinstellung, insbesondere eine Soll-Laserleistung, ausgebildeten Betriebsparameter der Lasereinheit 16, von dem als eine von der Lasereinheit 16 ausgebbare Laserleistung, insbesondere eine Ist-Laserleistung, ausgebildeten Betriebsparameter der Lasereinheit 16, von dem zumindest einen Betriebsparameter der Steuer- oder Regeleinheit 14 oder lediglich von dem zumindest einen Betriebsparameter des Verstärkers 34 der Lasereinheit 16 abhängt. Die Spannungskenngröße ist ein Spannungspegel oder dergleichen. Die Spannungskenngröße wird an einem Ausgang des Verstärkers 34 gemessen. Es ist denkbar, dass der Verstärker 34 als integrierte Schaltung implementiert ist. Eine Laserleistung, insbesondere eine Ist-Laserleistung, eines mittels der Lasereinheit 16 ausgebbaren Laserstrahls ist von der Spannungskenngröße, insbesondere dem Spannungspegel, vorzugsweise an dem Ausgang, des Verstärkers 34 abhängig.

## Patentansprüche

1. Verfahren zu einem Betrieb einer Regelungs- und Überwachungsvorrichtung (10) für einen Rotationslaser (12), wobei in einem Verfahrensschritt (22) mittels einer Steuer- oder Regeleinheit (14) der Regelungs- und Überwachungsvorrichtung (10) eine Laserleistung einer Lasereinheit (16) des Rotationslasers (12) in Abhängigkeit von einer Rotationsgeschwindigkeit eines Rotationskopfs (18) des Rotationslasers (12) geregelt wird, **dadurch gekennzeichnet, dass** mittels einer weiteren Steuer- oder Regeleinheit (20) der Regelungs- und Überwachungsvorrichtung (10) die Rotationsgeschwindigkeit des Rotationskopfs (18) und zumindest ein Betriebsparameter der Lasereinheit (16) abgefragt und abgeglichen wird, um ein Signal zu einer Beeinflussung eines mittels der Lasereinheit (16) ausgebbaren Laserstrahls auszugeben.

2. Verfahren nach einem der vorhergehenden Ansprüche, **dadurch gekennzeichnet, dass** mittels der weiteren Steuer- oder Regeleinheit (20) ein als eine von der Steuer- oder Regeleinheit (14) vorgenommene Laserleistungseinstellung oder ein als eine von der Lasereinheit (16) ausgebbare Laserleistung ausgebildeter Betriebsparameter der Lasereinheit (16) abgefragt wird.

3. Verfahren nach einem der vorhergehenden Ansprüche, **dadurch gekennzeichnet, dass** eine Blockier- und/oder Umlenkeinheit (24) der Regelungs- und Überwachungsvorrichtung (10) zu einem Blockieren bzw. Umlenken des mittels der Lasereinheit (16) ausgebbaren Laserstrahls in Abhängigkeit von dem mittels der weiteren Steuer- oder Regeleinheit (20) ausgebbaren Signal aktiviert wird.

4. Verfahren nach einem der vorhergehenden Ansprüche, **dadurch gekennzeichnet, dass** mittels der weiteren Steuer- oder Regeleinheit (20) zumindest ein Betriebsparameter der Steuer- oder Regeleinheit (14) abgefragt wird, um zumindest in Abhängigkeit von dem zumindest einen Betriebsparameter der Steuer- oder Regeleinheit (14) das Signal zu einer Beeinflussung des mittels der Lasereinheit (16) ausgebbaren Laserstrahls mittels der weiteren Steuer- oder Regeleinheit (20) auszugeben.

5. Verfahren nach einem der vorhergehenden Ansprüche, **dadurch gekennzeichnet, dass** mittels der Steuer- oder Regeleinheit (14) ein Sensorsignal eines Bewegungssensors (28) einer Sensoreinheit (26) des Rotationslasers (12) und mittels der weiteren Steuer- oder Regeleinheit (20) ein Sensorsignal eines weiteren Bewegungssensors (30) der Sensoreinheit (26) abgefragt wird, wobei eine Betriebsart, insbesondere eine durch eine Rotationsgeschwindigkeit und/oder durch eine Rotationsrichtung definierte Betriebsart, des Rotationskopfs (18) in Abhängigkeit von einer Auswertung einer zeitlichen Änderung der durch die Steuer- oder Regeleinheit (14) und die weitere Steuer- oder Regeleinheit (20) abgefragten Sensorsignale ermittelt wird.

6. Verfahren nach einem der vorhergehenden Ansprüche, **dadurch gekennzeichnet, dass** mittels der weiteren Steuer- oder Regeleinheit (20) zumindest ein Betriebsparameter, insbesondere eine Spannungskenngröße, eines Verstärkers (34), insbesondere eines Operationsverstärkers, der Lasereinheit (16) abgefragt wird, um zumindest in Abhängigkeit von dem zumindest einen Betriebsparameter des Verstärkers (34) das Signal zu einer Beeinflussung des mittels der Lasereinheit (16) ausgebbaren Laserstrahls mittels der weiteren Steuer- oder Regeleinheit (20) auszugeben.

7. Regelungs- und Überwachungsvorrichtung (10) für einen Rotationslaser (12), die zu einer Regelung einer Laserleistung einer Lasereinheit (16) des Rotationslasers (12) in Abhängigkeit von einer Betriebsart eines Rotationskopfs (18) des Rotationslasers (12) eingerichtet ist, insbesondere gemäß einem Verfahren nach einem der vorhergehenden Ansprüche, mit zumindest einer Steuer- oder Regeleinheit (14), die dazu eingerichtet ist, die Laserleistung der Lasereinheit (16) in Abhängigkeit von einer Rotationsgeschwindigkeit des Rotationskopfs (18) zu regeln, **gekennzeichnet durch** eine weitere Steuer- oder Regeleinheit (20),welche dazu eingerichtet ist, insbesondere unabhängig von der Steuer- oder Regeleinheit (14), die Rotationsgeschwindigkeit des Rotationskopfs (18) und zumindest einen Betriebsparameter der Lasereinheit (16) abzufragen und abzugleichen, um ein Signal zu einer Beeinflussung eines mittels der Lasereinheit (16) ausgebbaren Laserstrahls auszugeben, insbesondere um die Lasereinheit (16) zu deaktivieren.

8. Regelungs- und Überwachungsvorrichtung (10) nach Anspruch 7, **gekennzeichnet durch** eine Verbindungseinheit (36), die die weitere Steuer- oder Regeleinheit (20) zu einer Abfrage des zumindest einen Betriebsparameters der Lasereinheit (16) steuer- oder regeltechnisch mit der Lasereinheit (16) verbindet.

9. Regelungs- und Überwachungsvorrichtung (10) nach Anspruch 7 oder 8, **gekennzeichnet durch** eine Blockier- und/oder Umlenkeinheit (24) zu einem Blockieren und/oder zu einem Umlenken des mittels der Lasereinheit (16) ausgebbaren Laserstrahls, die durch das von der weiteren Steuer- oder Regeleinheit (20) ausgebbare Signal aktivierbar ist.

10. Rotationslaser (12) mit zumindest einer Lasereinheit (16), mit zumindest einem Rotationskopf (18), mit zumindest einer Antriebseinheit (32) zu einem Antrieb des Rotationskopfs (18) und mit zumindest einer Regelungs- und Überwachungsvorrichtung (10) nach einem der Ansprüche 7 bis 9.

11. Rotationslaser (12) nach Anspruch 10, **gekennzeichnet durch** eine Sensoreinheit (26), die zumindest zwei, insbesondere voneinander verschiedene, Bewegungssensoren (28, 30) aufweist, die zu einer Erfassung einer Rotationsgeschwindigkeit des Rotationskopfs (18) an der Antriebseinheit (32) oder an dem Rotationskopf (18) angeordnet sind.
